# EUROPEAN PATENT SPECIFICATION

(11) **EP 2 711 988 B1**
(45) Date of publication and mention of the grant of the patent: **28.12.2016**
(21) Application number: 13002313.8
(22) Date of filing: 30.04.2013
(51) Int. Cl.: H01L 31/0224, H01L 31/068

(54) **Solar cell and method for manufacturing the same**
Solarzelle und Verfahren zu ihrer Herstellung
Cellule solaire et son procédé de fabrication

(30) Priority: 19.09.2012 KR 20120103802
(43) Date of publication of application: 26.03.2014
(73) Proprietor: LG Electronics, Inc., Seoul, 150-721 (KR)
(72) Inventor: Nam, Jeongbeom, 137-724 Seoul (KR); Chung, Indo, 137-724 Seoul (KR); Jung, Ilhyoung, 137-724 Seoul (KR); Kim, Jinah, 137-724 Seoul (KR)
(74) Representative: Frenkel, Matthias Alexander

(56) References cited:
- JP-A- 2012 074 288
- KR-A- 20120 063 759
- US-A- 5 380 371
- US-A1- 2012 060 917
- US-A1- 2012 180 862
- US-A1- 2012 184 063

## Description

### BACKGROUND OF THE INVENTION

### Field of the Invention

Embodiments of the invention relate to a solar cell and a method for manufacturing the same.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, electrons and holes are produced in the semiconductor parts. The electrons move to the n-type semiconductor part, and the holes move to the p-type semiconductor part under the influence of the p-n junction of the semiconductor parts. Then, the electrons and the holes are collected by the different electrodes respectively connected to the n-type semiconductor part and the p-type semiconductor part. The electrodes are connected to each other using electric wires to thereby obtain electric power.

Document US 2012/0184063 A1 describes a solar cell including a substrate, an emitter part positioned at a front surface of the substrate on which light is incident, an anti-reflection layer positioned on the emitter part, and a front electrode part positioned on the emitter part. The front electrode part includes a plurality of front electrodes and a plurality of front bus bars. The plurality of front bus bars is connected to the front electrodes and is electrically and physically connected to the first and second emitter regions and of the emitter part.

From document US 5,380,371 A, a PIN-type amorphous solar cell is known. The solar cell comprises a solar cell main body, a substrate, a lower electrode, a n-type semiconductor layer, an i-type layer, a p-type layer, a transparent electrode, a passivation layer, an upper electrode, and a bus bar. The upper electrode serves as a pattern in forming the collector electrode, and is fabricated prior to the formation of the collector electrode, but fulfills the same function as that of the collector electrode. The collector electrode is fabricated by electroplating with a metal.

Document US2012/0060917 discloses a solar cell with finger electrodes comprising a seed layer and an electroplated layer, the seed layer being in contact with an emitter layer through openings etched in an insulating layer covering the emitter layer using a laser.

### SUMMARY OF THE INVENTION

In one aspect, there is a solar cell as defind in claim 1 including a substrate containing impurities of a first conductive type, an emitter region positioned at a first surface of the substrate, the emitter region containing impurities of a second conductive type opposite the first conductive type and including a lightly doped emitter region having a first sheet resistance and a heavily doped emitter region having a second sheet resistance less than the first sheet resistance, a first dielectric layer positioned on the emitter region, a first electrode including a first finger electrode, which is positioned on the heavily doped emitter region in a first direction, and a first bus bar electrode, which is positioned on the lightly doped emitter region in a second direction, and a second electrode which is positioned on a second surface of the substrate and is connected to the substrate, wherein the first finger electrode includes a seed layer contacting the heavily doped emitter region and a conductive metal layer formed on the seed layer, and the first bus bar electrode includes electrically conductive metal particles and a thermosetting resin.

The first dielectric layer is positioned between the first bus bar electrode and the lightly doped emitter region.

The electrically conductive metal particles may contain silver (Ag), and a size of each of the electrically conductive metal particles may be equal to or less than about 1 µm.

The thermosetting resin may include a monomer-based epoxy resin or an acrylic resin.

The first bus bar electrode may lack a glass frit or may include a glass frit equal to or less than about 10 % per unit volume of the first bus bar electrode. Further, the first bus bar electrode may lack a metal layer recrystallized at an interface between the first bus bar electrode and the emitter region.

The first finger electrode may be formed using a plating method. The seed layer may contain a nickel-silicide of nickel (Ni) and silicon (Si), and the conductive metal layer may contain at least one of tin (Sn), copper (Cu), and silver (Ag).

The lightly doped emitter region may directly contact the first dielectric layer, and the first bus bar electrode may directly contact the first dielectric layer.

The second electrode may include a second finger electrode positioned in the first direction, and a second bus bar electrode positioned in the second direction crossing the first direction.

The second finger electrode may include a seed layer and a conductive metal layer formed on the seed layer. The second bus bar electrode may include electrically conductive metal particles and a thermosetting resin.

In another aspect, there is a method for manufacturing a solar cell including forming a lightly doped emitter region having a first sheet resistance at a first surface of a substrate, forming a first dielectric layer on the lightly doped emitter region, coating a dopant paste on the first dielectric layer and irradiating a laser beam onto the dopant paste to form a heavily doped emitter region having a second sheet resistance less than the first sheet resistance, forming a first finger electrode on the heavily doped emitter region in a first direction and forming a first bus bar electrode on the lightly doped emitter region in a second direction to form a first electrode, and forming a second electrode on a second surface of the substrate, wherein the first finger electrode of the first electrode is formed using a plating method, wherein the forming of the first bus bar electrode of the first electrode includes coating a bus bar paste including electrically conductive metal particles and a thermosetting resin and performing a predetermined temperature process on the bus bar paste, as further defined in claim 9.

The predetermined temperature process of the bus bar paste may be performed at about 300 °C to 350 °C.

When the predetermined temperature process is performed on the bus bar paste, the bus bar paste may not pass through the first dielectric layer.

When the predetermined temperature process is performed on the bus bar paste, a recrystallized metal layer may be not formed at an interface between the bus bar paste and the emitter region.

A shape of the electrically conductive metal particles after performing the predetermined temperature process may be the same as a shape of the electrically conductive metal particles before performing the low temperature process.

The bus bar paste may lack a glass frit or may include a glass frit equal to or less than about 10 % per unit volume of the bus bar paste.

The thermosetting resin may include a monomer-based epoxy resin or an acrylic resin.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a partial perspective view of a solar cell according to a first embodiment of the invention;
FIG. 2A is a cross-sectional view taken along line IIA-IIA of FIG. 1;
FIG. 2B is a cross-sectional view taken along line IIB-IIB of FIG. 1;
FIG. 3 is a partial enlarged view of a first finger electrode shown in FIG. 2A;
FIG. 4 is a partial enlarged view of a first bus bar electrode shown in FIG. 2A;
FIG. 5 illustrates a structure of a related art bus bar electrode which is compared to a structure of a first bus bar electrode according to an embodiment of the invention;
FIGS. 6 to 7B illustrate a solar cell according to a second embodiment of the invention;
FIGS. 8 and 9 illustrate a solar cell according to a third embodiment of the invention;
FIGS. 10 and 11 illustrate a solar cell according to a fourth embodiment of the invention; and
FIGS. 12A to 12G illustrate a method for manufacturing a solar cell according to an example embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be paid attention that detailed description of known arts will be omitted if it is determined that the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

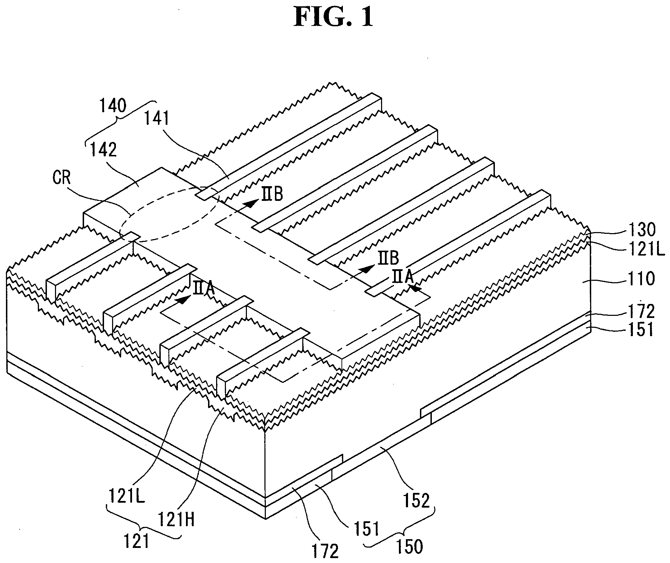

Example embodiments of the invention will be described with reference to FIGS. 1 to 12.

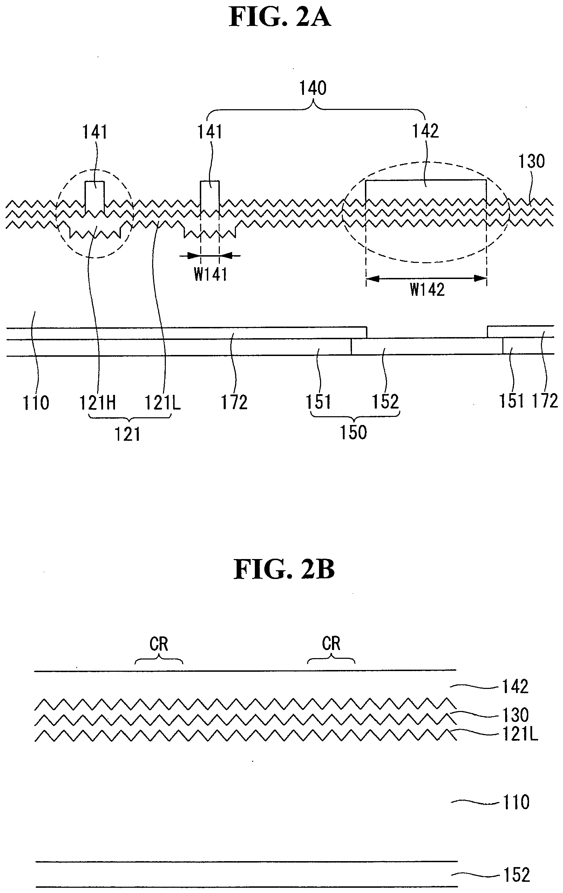

A solar cell according to a first embodiment of the invention is described in detail with reference to FIGS. 1 and 2.

FIG. 1 is a partial perspective view of a solar cell according to the first embodiment of the invention. FIG. 2A is a cross-sectional view taken along line IIA-IIA of FIG. 1, and FIG. 2B is a cross-sectional view taken along line IIB-IIB of FIG. 1.

As shown in FIGS. 1, 2A and 2B, the solar cell according to the first embodiment of the invention includes a substrate 110, an emitter region 121 positioned at a first surface of the substrate 110, a first dielectric layer 130 positioned on the emitter region 121, a first electrode 140 positioned on the emitter region 121, a back surface field region 172 positioned at a second surface opposite the first surface of the substrate 110, and a second electrode 150 positioned on the back surface field region 172 and the second surface of the substrate 110.

The substrate 110 may contain first conductive type impurities, for example, p-type impurities, though not required. For example, the substrate 110 may be a semiconductor substrate formed of a semiconductor such as silicon. The semiconductor used in the substrate 110 may be a crystalline semiconductor, such as single crystal silicon and polycrystalline silicon.

When the substrate 110 is of a p-type, the substrate 110 is doped with impurities of a group III element such as boron (B), gallium (Ga), and indium (In). Alternatively, the substrate 110 may be of an n-type and/or may be formed of a semiconductor material other than silicon. If the substrate 110 is of the n-type, the substrate 110 may be doped with impurities of a group V element such as phosphorus (P), arsenic (As), and antimony (Sb).

As shown in FIG. 1, the first surface of the substrate 110 may be textured to form a textured surface corresponding to an uneven surface having a plurality of uneven portions or having uneven characteristics. Hence, the first dielectric layer 130 positioned on the first surface of the substrate 110 may have the textured surface. Further, the second surface as well as the first surface of the substrate 110 may be textured.

A surface area of the substrate 110 may increase because of the textured surface of the substrate 110, and thus an incidence area of light may increase. Further, because an amount of light reflected by the substrate 110 may decrease, an amount of light incident on the substrate 110 may increase.

The emitter region 121 positioned at the first surface of the substrate 110 may contain impurities of a second conductive type (for example, n-type) opposite the first conductive type (for example, p-type) of the substrate 110. Thus, the emitter region 121 of the second conductive type forms a p-n junction along with a first conductive type region of the substrate 110.

Carriers, for example, electron-hole pairs produced by light incident on the substrate 110 are separated into electrons and holes by a built-in potential difference resulting from the p-n junction between the substrate 110 and the emitter region 121. The separated electrons move to the n-type semiconductor, and the separated holes move to the p-type semiconductor. Thus, when the substrate 110 is of the p-type and the emitter region 121 is of the n-type, the electrons move to the emitter region 121, and the holes move to the second surface of the substrate 110.

Because the emitter region 121 forms the p-n junction along with the substrate 110, the emitter region 121 may be of the p-type when the substrate 110 is of the n-type unlike the embodiment described above. In this instance, the electrons move to the second surface of the substrate 110, and the holes move to the emitter region 121.

Returning to the embodiment of the invention, when the emitter region 121 is of the n-type, the emitter region 121 may be doped with impurities of a group V element such as P, As, and Sb. On the contrary, when the emitter region 121 is of the p-type, the emitter region 121 may be doped with impurities of a group III element such as B, Ga, and In.

As shown in FIG. 1, the emitter region 121 may include a lightly doped emitter region 121L having a first sheet resistance and a heavily doped emitter region 121H having a second sheet resistance less than the first sheet resistance.

The lightly doped emitter region 121L is a region which is lightly doped with impurities of the second conductive type, and the heavily doped emitter region 121H is a region which is heavily doped with impurities of the second conductive type.

The first dielectric layer 130 may be positioned on the lightly doped emitter region 121L, and first finger electrodes 141 of the first electrode 140 may be positioned on the heavily doped emitter region 121H. Thus, the heavily doped emitter region 121H may extend in a first direction at a position overlapping the first finger electrodes 141.

The lightly doped emitter region 121L and the heavily doped emitter region 121H have the different sheet resistances because of a difference between doping concentrations of the impurities doped on the lightly doped emitter region 121L and the heavily doped emitter region 121H. Namely, the first sheet resistance of the lightly doped emitter region 121L may be greater than the second sheet resistance of the heavily doped emitter region 121 H.

For example, the sheet resistance of the lightly doped emitter region 121L may be about 100 Ω/sq. to 120 Ω/sq., and the sheet resistance of the heavily doped emitter region 121H may be about 30 Ω/sq. to 50 Ω/sq.

When the sheet resistance of the lightly doped emitter region 121L is about 100 Ω/sq. to 120 Ω/sq., an amount of light absorbed in the lightly doped emitter region 121L further decreases. Hence, an amount of light incident on the substrate 110 increases, and a loss of carriers resulting from the impurities is reduced.

Further, when the sheet resistance of the heavily doped emitter region 121H is about 30 Ω/sq. to 50 Ω/sq., a contact resistance between the heavily doped emitter region 121H and the first electrode 140 decreases. Hence, a loss of carriers resulting from the contact resistance in the movement of carriers is reduced.

Accordingly, the solar cell according to the first embodiment of the invention may have a selective emitter structure including the lightly doped emitter region 121L and the heavily doped emitter region 121H each having the different sheet resistance.

In the embodiment of the invention, impurity doping thicknesses of the lightly doped emitter region 121L and the heavily doped emitter region 121H may be different from each other. For example, an impurity doping thickness of the lightly doped emitter region 121L may be less than an impurity doping thickness of the heavily doped emitter region 121H.

The first dielectric layer 130 is be positioned on the emitter region 121. The first dielectric layer 130 may be formed of silicon nitride (SiNx), silicon oxide (SiOx), or silicon oxynitride (SiOxNy), each of which contains hydrogen (H). Other materials may be used for the first dielectric layer 130. FIG. 1 shows the first dielectric layer 130 having a single-layered structure as an example. Alternatively, the first dielectric layer 130 may have a multi-layered structure.

The first dielectric layer 130 reduces a reflectance of light incident on the solar cell and increases selectivity of a predetermined wavelength band, thereby increasing the efficiency of the solar cell. The first dielectric layer 130 may perform a passivation function, which converts a defect, for example, dangling bonds existing at and around the surface of the substrate 110 into stable bonds using hydrogen (H) contained in the first dielectric layer 130 to thereby prevent or reduce a recombination and/or a disappearance of carriers moving to the surface of the substrate 110. Thus, the first dielectric layer 130 reduces an amount of carriers lost by the defect at and around the surface of the substrate 110 to thereby improve the efficiency of the solar cell.

The first electrode 140 positioned on the emitter region 121 may include the plurality of first finger electrodes 141 and a plurality of first bus bar electrodes 142.

The first finger electrodes 141 may have the same pattern as the heavily doped emitter region 121H and may extend in the first direction. The first finger electrodes 141 may be positioned on the heavily doped emitter region 121H and may contact the heavily doped emitter region 121H.

Accordingly, the first finger electrodes 141 are electrically and physically connected to the heavily doped emitter region 121H of the emitter region 121. The first finger electrodes 141 may be separated from one another and may extend parallel to one another in a fixed direction. The first finger electrodes 141 may collect carriers (for example, electrons) moving to the heavily doped emitter region 121H.

The plurality of first bus bar electrodes 142 may be disposed in a second direction crossing the first finger electrodes 141.

The first bus bar electrodes 142 are positioned on the first dielectric layer 130 and contact the first dielectric layer 130, unlike the first finger electrodes 141. Namely, the first dielectric layer 130 is positioned between the first bus bar electrodes 142 and the emitter region 121, and the lightly doped emitter region 121L is positioned under the first bus bar electrodes 142. The first bus bar electrodes 142 may be directly contacted on the first dielectric layer 130 in embodiments of the invention.

The first bus bar electrodes 142 are positioned on the same level layer as the first finger electrodes 141 and are electrically and physically connected to the first finger electrodes 141 at a position CR crossing the first finger electrodes 141.

As shown in FIGS. 1 and 2B, the first finger electrodes 141 may be formed to be separated from each other at the position CR crossing the first bus bar electrode 142. Namely, the first finger electrodes 141 may be formed to be separated from each other with the first bus bar electrode 142 interposed between the first finger electrodes 141. Alternatively, other configurations may be used.

As shown in FIG. 1, the plurality of first finger electrodes 141 have a stripe shape extending in a transverse (or longitudinal) direction, and the plurality of first bus bar electrodes 142 have a stripe shape extending in the direction crossing the first finger electrodes 141, for example, in a longitudinal (or transverse) direction. Hence, the first electrode 140 has a lattice shape on the first surface of the substrate 110.

FIGS. 1 and 2B show that the first finger electrode 141 and the first bus bar electrode 142 have the same thickness as an example. Alternatively, a thickness of the first bus bar electrode 142 may be greater than a thickness of the first finger electrode 141.

The first bus bar electrodes 142 may collect carriers, which are collected by the first finger electrodes 141 and move, and then may transmit the collected carriers to an external device, for example, an adjacent solar cell or a junction box in a corresponding direction.

The first bus bar electrodes 142 have to collect carriers collected by the first finger electrodes 141 crossing the first bus bar electrodes 142 and have to move the collected carriers in a desired direction. Therefore, a width W142 of each first bus bar electrode 142 may be greater than a width W141 of each first finger electrode 141, so as to reduce a resistance.

More specifically, the width W142 of the first bus bar electrode 142 may be about 50 to 600 times the width W141 of the first finger electrode 141. For example, the width W141 of the first finger electrode 141 may be about 5 µm to 20 µm, and the width W142 of the first bus bar electrode 142 may be about 1 mm to 3 mm.

In the embodiment of the invention, the number of first finger electrodes 141 and the number of first bus bar electrodes 142 may vary, if desired or necessary.

The back surface field region 172 positioned at the second surface of the substrate 110 is a region (for example, a p⁺-type region) which is more heavily doped than the substrate 110 with impurities of the same conductive type as the substrate 110.

A potential barrier is formed by a difference between impurity doping concentrations of the first conductive type region of the substrate 110 and the back surface field region 172. Hence, the potential barrier prevents or reduces electrons from moving to the back surface field region 172 used as a moving path of holes and makes it easier for holes to move to the back surface field region 172. Thus, the back surface field region 172 reduces an amount of carriers lost by a recombination and/or a disappearance of electrons and holes at and around the second surface of the substrate 110 and accelerates a movement of desired carriers (for example, holes), thereby increasing the movement of carriers to the second electrode 150.

The second electrode 150 includes a back electrode layer 151 and a plurality of second bus bar electrodes 152 connected to the back electrode layer 151.

The back electrode layer 151 contacts the back surface field region 172 positioned at the second surface of the substrate 110. The back electrode layer 151 may be substantially positioned on the entire second surface of the substrate 110 except a formation area of the second bus bar electrodes 152.

The back electrode layer 151 may contain a conductive material, for example, aluminum (Al). The back electrode layer 151 may collect carriers (for example, holes) moving to the back surface field region 172.

Because the back electrode layer 151 contacts the back surface field region 172 having the impurity doping concentration higher than the substrate 110, a contact resistance between the back surface field region 172 and the back electrode layer 151 decreases. Hence, the transfer efficiency of carriers from the substrate 110 to the back electrode layer 151 is improved.

The plurality of second bus bar electrodes 152 are positioned on the second surface of the substrate 110, on which the back electrode layer 151 is not positioned, and are connected to the back electrode layer 151.

As shown in FIGS. 1 and 2A, the second bus bar electrodes 152 may be disposed at a position overlapping (or facing) the first bus bar electrodes 142.

The second bus bar electrodes 152 collect carriers transmitted from the back electrode layer 151, similar to the first bus bar electrodes 142.

The second bus bar electrodes 152 are connected to the external device, and thus carriers (for example, holes) collected by the second bus bar electrodes 152 are output to the external device.

The second bus bar electrodes 152 may be formed of a material having better conductivity than the back electrode layer 151. For example, the second bus bar electrodes 152 may contain at least one conductive material such as silver (Ag).

The solar cell having the above-described structure may be electrically formed to an adjacent solar cell by forming an interconnector such as a conductive film on the first bus bar electrodes 142 and the second bus bar electrodes 152.

An operation of the solar cell having the above-described structure is described below.

When light irradiated to the solar cell is incident on the substrate 110 through the first dielectric layer 130, a plurality of electron-hole pairs are generated in the semiconductor part by light energy produced based on the incident light. In this instance, because a reflection loss of the light incident on the substrate 110 is reduced by the textured surface of the substrate 110 and the first dielectric layer 130, an amount of light incident on the substrate 110 increases.

The electron-hole pairs are separated into electrons and holes due to the p-n junction of the substrate 110 and the emitter region 121. The electrons move to the n-type emitter region 121, and the holes move to the p-type substrate 110. The electrons moving to the emitter region 121 are collected by the first finger electrodes 141 and the first bus bar electrodes 142 and move along the first bus bar electrodes 142. The holes moving to the substrate 110 are collected by the back electrode layer 151 and the second bus bar electrodes 152 and move along the second bus bar electrodes 152. When the first bus bar electrodes 142 are connected to the second bus bar electrodes 152 using conductive wires, current flows therein to thereby enable use of the current for electric power.

In the embodiment of the invention, a loss amount of carriers decreases due to the emitter region 121 having the selective emitter structure, and an amount of carriers moving to the first electrode 140 increases. Hence, the efficiency of the solar cell is greatly improved.

In the solar cell according to the embodiment of the invention, the first bus bar electrodes 142 contain a different material from the first finger electrodes 141.

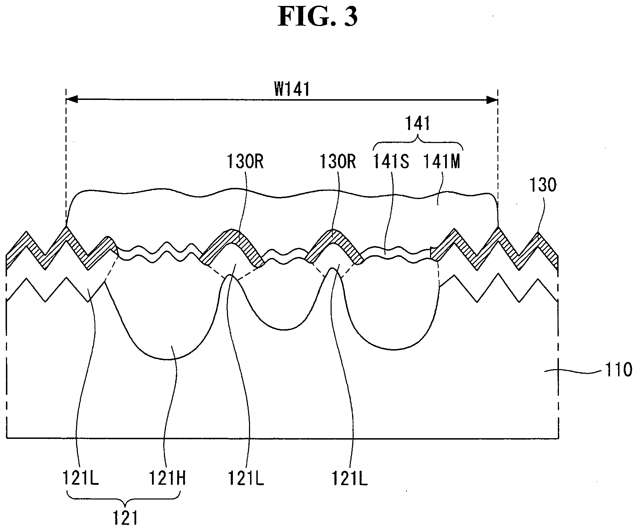

For example, the first finger electrodes 141 may be formed using a plating method. Hence, the first finger electrodes 141 may be formed using a seed layer 141S (see FIG. 3) formed on the heavily doped emitter region 121H and a conductive metal layer 141M formed on the seed layer 141S. The first finger electrodes 141 may be formed of at least one of tin (Sn), copper (Cu), silver (Ag), nickel (Ni), and nickel-silicide of nickel (Ni) and silicon (Si).

Further, the first bus bar electrodes 142 may be formed by coating a paste containing a conductive material and then drying the paste. The first bus bar electrodes 142 may include electrically conductive metal particles and a thermosetting resin. Thus, the first bus bar electrodes 142 may contain a material which is not contained in the first finger electrodes 141.

As described above, the first finger electrodes 141 and the first bus bar electrodes 142 may have different structures due to different manufacturing methods between them. Hence, the efficiency and the productivity of the solar cell may be improved due to the different manufacturing methods between the first finger electrodes 141 and the first bus bar electrodes 142.

As described above, the first finger electrodes 141 may be formed using the plating method.

When the first finger electrodes 141 are formed using the plating method, the first finger electrodes 141 may be more simply manufactured because a separate alignment process is not required. Further, because an area, to which heat is applied, is reduced, a damage of the emitter region 121 or the substrate 110 resulting from the high heat may be reduced. Furthermore, when the first finger electrodes 141 are manufactured, a shunt phenomenon, in which the first finger electrodes 141 pass through the emitter region 121 and contact the substrate 110, is prevented.

On the other hand, it is difficult to use the plating method when the first bus bar electrodes 142 are manufactured. This reason is described below.

The first dielectric layer 130 positioned on the emitter region 121 has to be removed using a laser beam, so as to perform the plating method. In this instance, when the first dielectric layer 130 is removed using the laser beam, the substrate 110 and the emitter region 121 are damaged by the heat of the laser beam. Therefore, it is important to reduce an irradiation range of the laser beam.

The width W142 of the first bus bar electrode 142 is about 50 to 600 times greater than the width W141 of the first finger electrode 141. If the first bus bar electrodes 142 having the wide width are manufactured using the plating method, a manufacturing time of the first bus bar electrodes 142 may greatly increase. Further, an irradiation time and an irradiation amount of the laser beam onto the substrate 110 and the emitter region 121 may increase. Hence, a photoelectric conversion efficiency of the substrate 110 and the emitter region 121 maybe greatly reduced.

Accordingly, in the embodiment of the invention, the first bus bar electrodes 142 are formed using a bus bar paste including electrically conductive metal particles and a thermosetting resin as described above. The bus bar paste for forming the first bus bar electrodes 142 may be used in a low temperature process (for example, about 300 °C to 350 °C), unlike a related art paste requiring a high temperature process (for example, about 800 °C to 900 °C). Thus, an influence of temperature on the substrate 110 and the emitter region 121 may be reduced. Hence, the efficiency of the solar cell may be further improved. In embodiments of the invention, the low temperature process may also be referred to as a predetermined temperature process or a predetermined temperature heating.

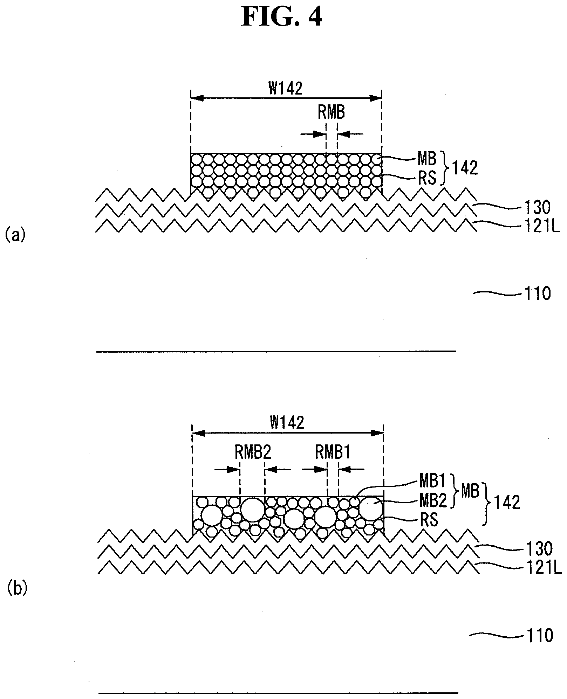

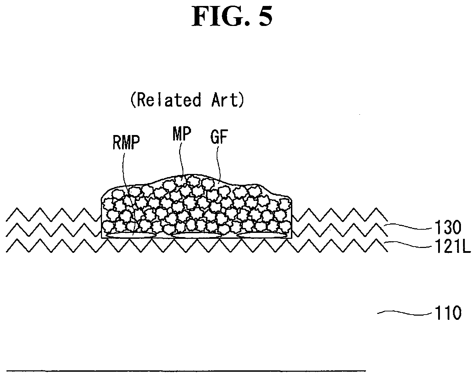

The first bus bar electrodes 142 formed using the bus bar paste according to the embodiment of the invention have a different structure from the first bus bar electrodes formed using the related art paste. This is described in detail with reference to FIGS. 4 and 5.

FIG. 3 illustrates in detail a structure of the first finger electrode 141.

More specifically, FIG. 3 is a partial enlarged view of the first finger electrode 141 shown in FIG. 2A, so as to describe the structure of the first finger electrode 141.

As shown in FIG. 3, the first finger electrode 141 according to the embodiment of the invention may include a seed layer 141S and a conductive metal layer 141 M.

As shown in FIG. 3, the heavily doped emitter region 121H may be formed under the first finger electrode 141, and a remainder 130R of the first dielectric layer 130 may remain in a portion of the first finger electrode 141. The remainder 130R of the first dielectric layer 130 may be the same as the material of the first dielectric layer 130. Alternatively, the remainder 130R of the first dielectric layer 130 may not remain unlike FIG. 3.

In a process for removing the first dielectric layer 130 positioned on the emitter region 121 to form the first finger electrode 141, existence of the remainder 130R of the first dielectric layer 130 may depend on a power strength or a moving velocity of the irradiated laser beam.

Namely, as shown in FIG. 3, when the power strength of the irradiated laser beam relatively decreases or the moving velocity of the irradiated laser beam relatively increases, the remainder 130R of the first dielectric layer 130 may be formed under the first finger electrode 141. On the contrary, unlike FIG. 3, when the power strength of the irradiated laser beam relatively increases or the moving velocity of the irradiated laser beam relatively decreases, the remainder 130R of the first dielectric layer 130 may not be formed under the first finger electrode 141.

As shown in FIG. 3, the seed layer 141S of the first finger electrode 141 may be positioned on the heavily doped emitter region 121H, and the conductive metal layer 141M of the first finger electrode 141 may be formed on the seed layer 141S.

For example, the seed layer 141S may contain nickel (Ni), and the conductive metal layer 141M may contain at least one of tin (Sn), copper (Cu), and silver (Ag).

For example, the conductive metal layer 141M may include only a layer containing silver (Ag) or may be formed by stacking a layer containing tin (Sn) on a layer containing copper (Cu).

FIG. 3 shows that the seed layer 141S containing nickel (Ni) directly contacts the heavily doped emitter region 121H. However, the first finger electrode 141 may further include a nickel-silicide layer, which is generated by chemical bonding between nickel (Ni) and silicon (Si) through a silicidation process, at an interface between the seed layer 141S and the heavily doped emitter region 121H.

When the conductive metal layer 141M contains copper (Cu), the nickel-silicide layer may prevent copper (Cu) of the conductive metal layer 141M from being diffused into the heavily doped emitter region 121 H and thus may prevent a reduction in a function of the heavily doped emitter region 121H.

The nickel-silicide layer may be formed in the low temperature process for forming the bus bar paste according to the embodiment of the invention.

The first finger electrode 141 has the specific structure which is able to be formed through the plating method. The first finger electrode 141 is grown and formed on the heavily doped emitter region 121H exposed through a portion of the first dielectric layer 130 which is removed through the irradiation of the laser beam.

Accordingly, unlike the related art, the embodiment of the invention does not require the separate alignment process and thus may further simplify the manufacturing process of the first finger electrodes 141. Further, the embodiment of the invention irradiates the laser beam only onto a minimum area of the solar cell and thus may reduce a heat damage of the emitter region 121 or the substrate 110. Furthermore, the embodiment of the invention may prevent the shunt phenomenon, in which the first finger electrodes 141 pass through the emitter region 121 and contact the substrate 110, when the first finger electrodes 141 are manufactured and thus may further improve the production yield of the solar cell.

FIGS. 4 and 5 illustrate in detail a difference between a structure of the first bus bar electrode 142 and a structure of a related art bus bar electrode.

More specifically, FIG. 4 is a partial enlarged view of the first bus bar electrode 142 shown in FIG. 2A so as to describe the structure of the first bus bar electrode 142. FIG. 5 illustrates a structure of a related art bus bar electrode which is compared to the structure of the first bus bar electrode according to the embodiment of the invention.

As shown in (a) and (b) of FIG. 4, the first bus bar electrode 142 according to the embodiment of the invention contacts not the emitter region 121 but the first dielectric layer 130 and is positioned on the first dielectric layer 130. The first bus bar electrode 142 includes a plurality of electrically conductive metal particles MB and a thermosetting resin RS.

The metal particles MB may contain an electrically conductive metal material, for example, silver (Ag) with very good electrical conductivity. The metal particles MB may have the same shape as the metal particles MB before the low temperature process is performed on the first bus bar electrode 142.

For example, if the metal particles MB have a circle shape or an oval shape before performing the low temperature process, the metal particles MB may maintain the circle shape or the oval shape after performing the low temperature process.

The plurality of metal particles MB may be electrically connected to one another. As shown in (a) of FIG. 4, the metal particles MB may be arranged in a lattice shape. Alternatively, a plurality of rows each including the metal particles MB may be intercrossed. Alternatively, the metal particles MB may be non-uniformly arranged without a specific arrangement rule.

As shown in (a) of FIG. 4, the metal particles MB of the first bus bar electrode 142 may have the uniform size. For example, the size of each of the metal particles MB may be equal to or less than about 1 µm. For example, when the metal particles MB have the circle shape shown in (a) of FIG. 4, a diameter RMB of each metal particle MB may be equal to or less than about 1 µm.

On the other hand, as shown in (b) of FIG. 4, metal particles MB of the first bus bar electrode 142 may include metal particles MB1 each having a first diameter RMB1 equal to or less than about 1 µm and metal particles MB2 each having a second diameter RMB2 greater than the first diameter RMB1. In this instance, the second diameter RMB2 may be greater than about 1 µm and may be equal to or less than about 10 µm.

As shown in (a) and (b) of FIG. 4, the thermosetting resin RS may be disposed between the metal particles MB. The thermosetting resin RS coheres the metal particles MB and is hardened in the low temperature process (for example, about 300 °C to 350 °C), thereby increasing a strength of the first bus bar electrode 142.

Although the low temperature process is performed on the bus bar paste forming the first bus bar electrode 142, the thermosetting resin RS according to the embodiment of the invention is not evaporated and remains in the first bus bar electrode 142.

The first bus bar electrode 142 according to the embodiment of the invention may further include an initiator generating a polymerization reaction. The initiator generates the polymerization reaction when the low temperature process is performed on the bus bar paste, to cohere the metal particles MB in an initial stage and to increase the strength of the first bus bar electrode 142.

Accordingly, even if the bus bar paste forming the first bus bar electrode 142 according to the embodiment of the invention includes another material (for example, the initiator) in addition to the metal particles MB and the thermosetting resin RS, the thermosetting resin RS may occupy about 90% or more of the bus bar paste in a state where the metal particles MB is excluded from the bus bar paste.

Further, because the first bus bar electrode 142 according to the embodiment of the invention includes the thermosetting resin RS which is formed of a nonvolatile material and coheres the metal particles MB, the first bus bar electrode 142 may not include a glass frit for cohering the electrically conductive metal material. Alternatively, even if the first bus bar electrode 142 includes the glass frit, an amount of the glass frit may be equal to or less than about 10 % per unit volume of the first bus bar electrode 142.

When the first bus bar electrode 142 includes the glass frit formed of a nonconductive material, a resistance of the first bus bar electrode 142 increases. Thus, it is preferable that the first bus bar electrode 142 includes a minimum amount of glass frit. In the following description, the first bus bar electrode 142 does not include (i.e., lacks) the glass frit as an example.

The comparison between the first bus bar electrode 142 according to the embodiment of the invention and the related art bus bar electrode shown in FIG. 5 is described below.

The first bus bar electrode 142 according to the embodiment of the invention is formed through the low temperature process (for example, about 300 °C to 350 °C) and does not include the glass frit. Thus, as shown in FIG. 4, the first bus bar electrode 142 is positioned on the first dielectric layer 130.

On the other hand, as shown in FIG. 5, the related art bus bar electrode is formed through the high temperature process (for example, about 800 °C to 900 °C) and includes a glass frit GF. Therefore, the related art bus bar electrode passes through the first dielectric layer 130 and contacts the emitter region 121 in the high temperature process.

Because the first bus bar electrode 142 according to the embodiment of the invention includes the thermosetting resin RS formed of the nonvolatile material, the thermosetting resin RS remains in the first bus bar electrode 142, which is finally completed, even if the low temperature process is performed on the first bus bar electrode 142.

On the other hand, as shown in FIG. 5, even if a paste forming the related art bus bar electrode includes a resin serving as a binder, the resin is completely removed in the high temperature process. Hence, the resin does not remain in the related art bus bar electrode, which is finally completed.

Because the low temperature process (for example, about 300 °C to 350 °C) is performed on the first bus bar electrode 142 according to the embodiment of the invention, the metal particles MB remaining in the bus bar paste maintain an original shape. Hence, the metal particles MB of the first bus bar electrode 142, which is finally completed, maintain the original shape, for example, the circle shape or the oval shape shown in FIG. 4.

On the other hand, as shown in FIG. 5, even if a metal material MP of a paste state before performing the thermal process has a circle shape or an oval shape, the metal material MP of the related art bus bar electrode, which is finally completed, does not have the circle shape or the oval shape because a temperature of the thermal process is relatively high, for example, about 800 °C to 900 °C. Namely, the metal material MP is partially or entirely melted by heat. Thus, the metal material MP of the related art bus bar electrode, which is finally completed, has the shape, in which the metal material MP is partially or entirely melted, unlike the circle shape or the oval shape.

As shown in FIG. 5, because the temperature of the thermal process is relatively high, for example, about 800 °C to 900 °C, a portion of the metal material MP of the related art bus bar electrode, which is finally completed, is completely melted to the extent that the metal material MP cannot show its original shape, and then runs to the bottom of the related art bus bar electrode. In a subsequent drying process, the metal material MP reacts with silicon contained in the emitter region 121 at an interface between the related art bus bar electrode and the emitter region 121 to form a recrystallized metal layer RMP. On the other hand, as shown in FIG. 4, because the low temperature process (for example, about 300 °C to 350 °C) is performed on the first bus bar electrode 142 according to the embodiment of the invention, the first bus bar electrode 142 does not include (i.e., lacks) the recrystallized metal layer RMP.

The first bus bar electrode 142 of the solar cell according to the embodiment of the invention does not include the glass frit GF and is formed using the bus bar paste which can be used in the low temperature process. Therefore, the damage of the emitter region 121 and the substrate 110 resulting from heat may be minimized, and the efficiency of the solar cell may be further improved.

FIGS. 1 and 2 show that the first finger electrodes 141 are positioned on opposite sides of the first bus bar electrode 142 and thus are separated from one another. Other structures may be used for the first electrode 140.

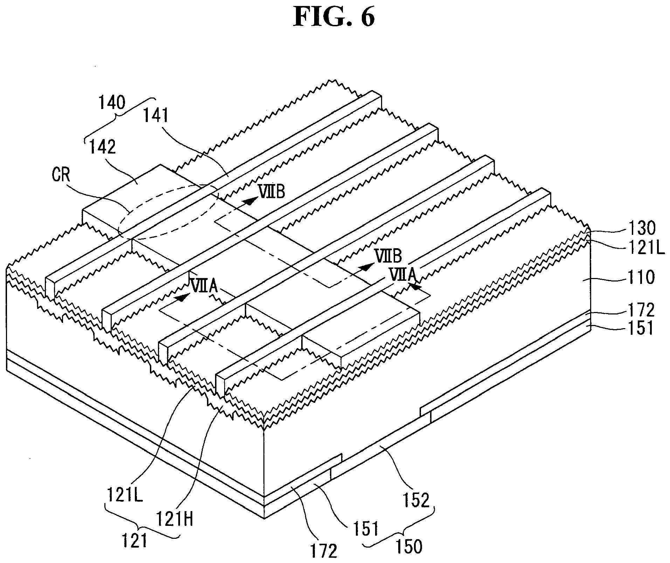

FIGS. 6 to 7B illustrate a solar cell according to a second embodiment of the invention.

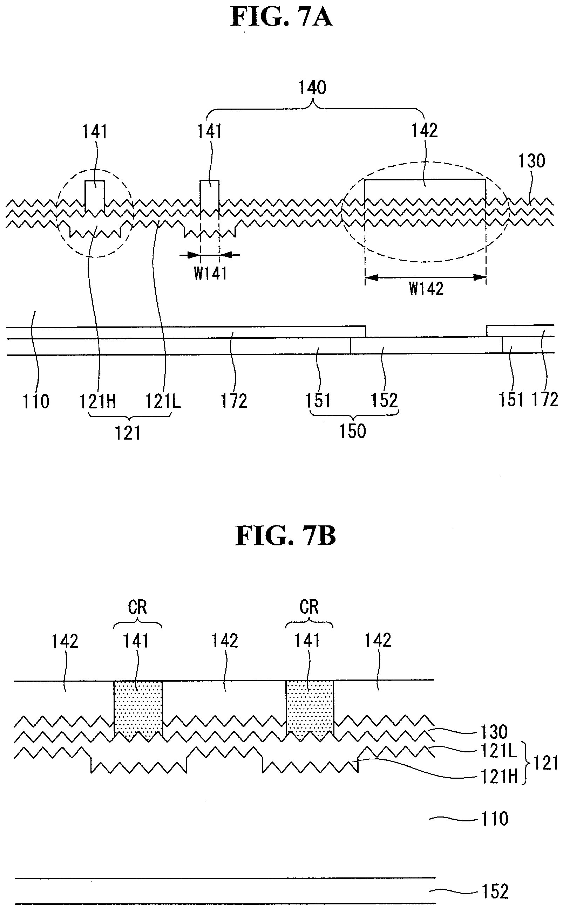

More specifically, FIG. 6 is a partial perspective view of a solar cell according to the second embodiment of the invention. FIG. 7A is a cross-sectional view taken along line VIIA-VIIA of FIG. 6, and FIG. 7B is a cross-sectional view taken along line VIIB-VIIB of FIG. 6.

FIGS. 1 and 2 show that the first finger electrodes 141 are positioned on opposite sides of the first bus bar electrode 142 and thus are separated from one another. On the other hand, as shown in FIGS. 6 to 7B, first finger electrodes 141 of a first electrode 140 may not be separated at positions CR crossing first bus bar electrodes 142.

In other words, in the second embodiment of the invention, the first finger electrode 141 may not be separated and may extend even at the crossing CR between the first finger electrode 141 and the first bus bar electrode 142.

Accordingly, the configuration shown in FIG. 7A is substantially the same as the configuration shown in FIG. 2A, and the configuration of FIG. 7B showing a cross-sectional view of the first bus bar electrode 142 is different from the configuration shown in FIG. 2B. Namely, a heavily doped emitter region 121H may be disposed under the crossing CR between the first finger electrode 141 and the first bus bar electrode 142.

Further, in this instance, as shown in FIG. 7B, the first bus bar electrode 142 does not directly contact the heavily doped emitter region 121H or a lightly doped emitter region 121L, and a first dielectric layer 130 may be positioned between an emitter region 121 including the heavily doped emitter region 121H and the lightly doped emitter region 121L and the first bus bar electrode 142.

Further, FIGS. 6 to 7B show that a height of an end of the first finger electrode 141 is substantially equal to a height of an end of the first bus bar electrode 142. Alternatively, the height of the end of the first finger electrode 141 may be less than the height of the end of the first bus bar electrode 142.

Accordingly, unlike FIG. 7B, the first bus bar electrode 142 may cover the first finger electrode 141 at the crossing CR between the first finger electrode 141 and the first bus bar electrode 142.

In the second embodiment of the invention, the first finger electrode 141 and the first bus bar electrode 142 of the first electrode 140 are manufactured using different manufacturing methods, the first finger electrode 141 includes a seed layer 141S and a conductive metal layer 141M, and the first bus bar electrode 142 includes a plurality of electrically conductive metal particles MB and a thermosetting resin RS, in the same manner as the first embodiment. A second electrode 150 according to the second embodiment of the invention is different from the second electrode 150 according to the first embodiment.

The second electrode 150 according to the second embodiment may include a second finger electrode 151 positioned in a first direction and a second bus bar electrode 152 positioned in a second direction crossing the first direction, in the same manner as the first electrode 140.

In this instance, the second finger electrode 151 may have a structure including the seed layer 141S and the conductive metal layer 141M, and the second bus bar electrode 152 may have a structure including the electrically conductive metal particles MB and the thermosetting resin RS.

As described above, when the second electrode 150 includes the second finger electrode 151 including the seed layer 141S and the conductive metal layer 141M and the second bus bar electrode 152 including the electrically conductive metal particles MB and the thermosetting resin RS, the solar cell according to the second embodiment of the invention may be a bifacial solar cell.

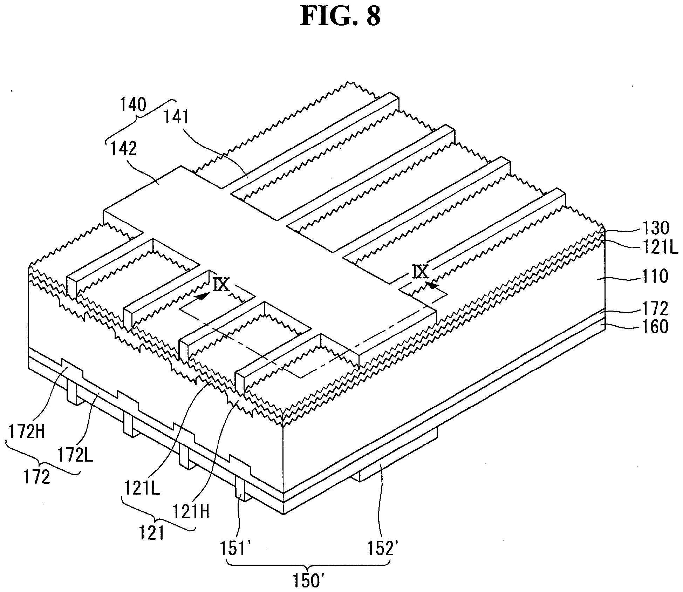

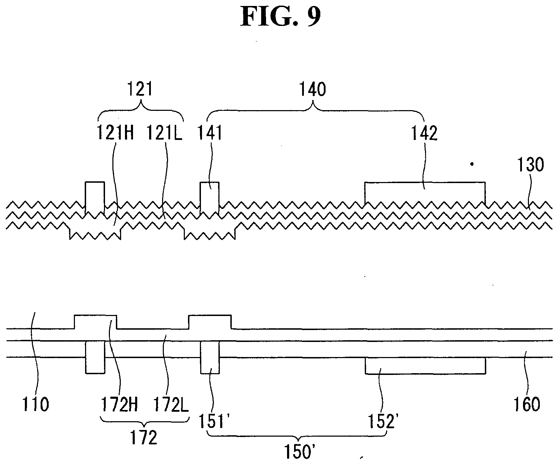

FIGS. 8 and 9 illustrate a solar cell according to a third embodiment of the invention. More specifically, FIG. 8 is a partial perspective view of a bifacial solar cell, and FIG. 9 is a cross-sectional view taken along line IX-IX of FIG. 8.

As shown in FIGS. 8 and 9, the solar cell according to the third embodiment of the invention may include a substrate 110, an emitter region 121 which is positioned at a first surface of the substrate 110 and includes a heavily doped emitter region 121H and a lightly doped emitter region 121L, a first dielectric layer 130 positioned on the emitter region 121, a first electrode 140 which is positioned on the emitter region 121 and includes a plurality of first finger electrodes 141 and a plurality of first bus bar electrodes 142, a back surface field region 172 which is positioned at a second surface of the substrate 110 and includes a heavily field region 172H and a lightly field region 172L, a second dielectric layer 160 positioned on the back surface field region 172, and a second electrode 150' which is positioned on the back surface field region 172 and includes a plurality of second finger electrodes 151' and a plurality of second bus bar electrodes 152'. The solar cell according to the third embodiment of the invention may have a structure of a bifacial solar cell.

The substrate 110, the emitter region 121, the first dielectric layer 130, and the first electrode 140 according to the third embodiment of the invention may use a description thereof illustrated in FIGS. 1 to 7.

Accordingly, since configurations of the substrate 110, the emitter region 121, the first dielectric layer 130, and the first electrode 140 according to the third embodiment of the invention are substantially the same as the first and second embodiments of the invention, a further description may be briefly made or may be entirely omitted.

The back surface field region 172, the second dielectric layer 160, and the second electrode 150' have the same function as FIGS. 1 to 2B, and thus a further description may be briefly made or may be entirely omitted. Structural differences between them are described below.

A material of the second dielectric layer 160 positioned on the back surface field region 172 may be the same as a material of the first dielectric layer 130 (i.e., the material of the first dielectric layer 130 illustrated in FIGS. 1 to 2B).

The back surface field region 172 positioned at the second surface of the substrate 110 may be a region (for example, a p⁺-type region) which is more heavily doped than the substrate 110 with impurities of the same conductive type as the substrate 110.

The back surface field region 172 according to the third embodiment of the invention may have a structure including the heavily field region 172H and the lightly field region 172L. The structure of the back surface field region 172 is not necessary and may be selectively applied. Other structures may be used.

The lightly field region 172L is a region (for example, a p⁺-type region) which is doped with impurities of the same conductive type as the substrate 110 at a first concentration. The heavily field region 172H is a region (for example, a p⁺⁺-type region) which is doped with impurities of the same conductive type as the substrate 110 at a second concentration higher than the first concentration. The heavily field region 172H may be positioned in the same first direction as the second finger electrodes 151' and may directly contact the second finger electrodes 151'.

The second electrode 150' may be positioned on the back surface field region 172 and may include the second finger electrodes 151' positioned in the first direction and the second bus bar electrodes 152' positioned in a second direction crossing the first direction.

The second finger electrodes 151' may be formed on the heavily field region 172H in the first direction in the same pattern as the heavily field region 172H and may contact the heavily field region 172H.

Accordingly, the second finger electrodes 151' may be electrically and physically connected to the heavily field region 172H, may be separated from one another, and may extend parallel to one another in a fixed direction.

The second bus bar electrodes 152' may be positioned on the second dielectric layer 160 in the second direction crossing the second finger electrodes 151' and may contact the second dielectric layer 160. Namely, the second dielectric layer 160 may be positioned between the second bus bar electrodes 152' and the back surface field region 172, and the lightly field region 172L may be positioned under the second bus bar electrodes 152'.

The second finger electrode 151' may have a structure including a seed layer and a conductive metal layer in the same manner as the first finger electrode 141 shown in FIG. 3. Further, the second bus bar electrode 152' may have a structure including electrically conductive metal particles and a thermosetting resin in the same manner as the first bus bar electrode 142 shown in FIG. 4.

Since configuration of the second finger electrode 151' including the seed layer and the conductive metal layer is substantially the same as the first finger electrode 141 shown in FIG. 3, a further description may be briefly made or may be entirely omitted.

Further, since configuration of the second bus bar electrode 152' including the electrically conductive metal particles and the thermosetting resin is substantially the same as the first bus bar electrode 142 shown in FIG. 4, a further description may be briefly made or may be entirely omitted.

In the embodiment of the invention, the first electrode 140 including the first finger electrode 141 including the seed layer 141S and the conductive metal layer 141 M and the first bus bar electrode 142 including the electrically conductive metal particles MB and the thermosetting resin RS may be applied to a solar cell of a passivated emitter and rear cell (PERC) structure.

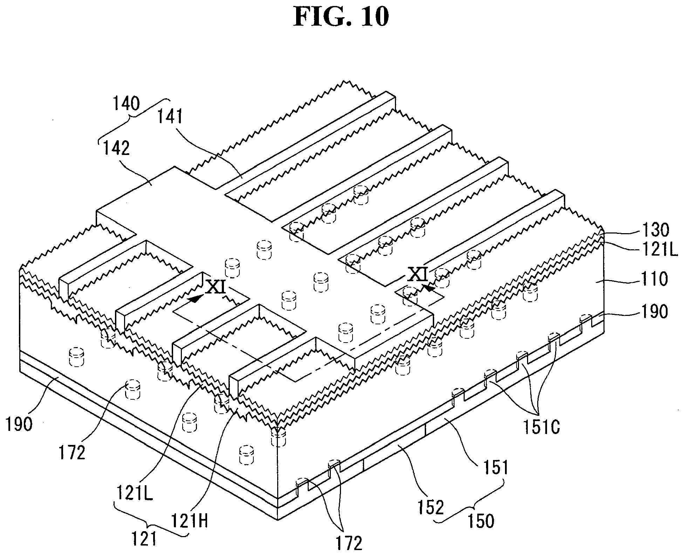

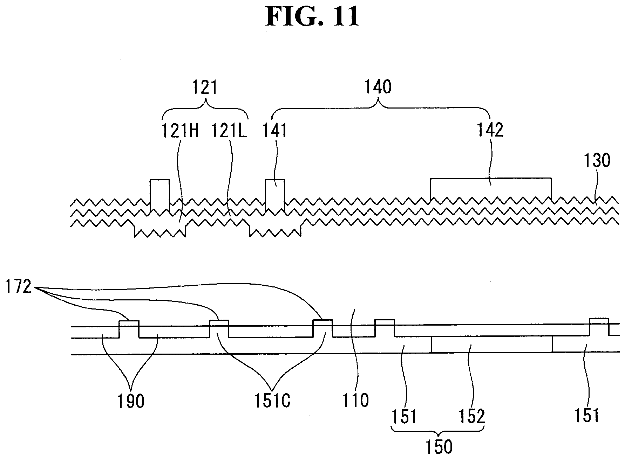

FIGS. 10 and 11 illustrate a solar cell according to a fourth embodiment of the invention.

More specifically, FIG. 10 is a partial perspective view of a solar cell of a PERC structure, and FIG. 11 is a cross-sectional view taken along line XI-XI of FIG. 10.

As shown in FIGS. 10 and 11, the solar cell according to the fourth embodiment of the invention may include a substrate 110, an emitter region 121 which is positioned at a first surface of the substrate 110 and includes a heavily doped emitter region 121H and a lightly doped emitter region 121L, a first dielectric layer 130 positioned on the emitter region 121, a first electrode 140 which is positioned on the emitter region 121 and includes a plurality of first finger electrodes 141 and a plurality of first bus bar electrodes 142, a plurality of back surface field regions 172 partially positioned at a second surface of the substrate 110, a back passivation layer 190 positioned on the second surface of the substrate 110, and a second electrode 150 which is positioned on the second surface of the substrate 110 and includes a back electrode layer 151 and a plurality of second bus bar electrodes 152.

The substrate 110, the emitter region 121, the first dielectric layer 130, and the first electrode 140 according to the fourth embodiment of the invention may use a description thereof illustrated in FIGS. 1 to 7.

Accordingly, since configurations of the substrate 110, the emitter region 121, the first dielectric layer 130, and the first electrode 140 according to the fourth embodiment of the invention are substantially the same as the first and second embodiments of the invention, a further description may be briefly made or may be entirely omitted.

The plurality of back surface field regions 172 are positioned between the second electrode 150 and the substrate 110. Each of the back surface field regions 172 may be a region (for example, a p⁺-type region) which is more heavily doped than the substrate 110 with impurities of the same conductive type as the substrate 110.

The plurality of back surface field regions 172 are positioned between the second electrode 150 and the substrate 110 and are partially formed only at connection portions between the second electrode 150 and the substrate 110 through a plurality of holes of the back passivation layer 190.

The back passivation layer 190 is positioned on the second surface of the substrate 110 and has the plurality of holes.

The back passivation layer 190 prevents or reduces a recombination and/or a disappearance of carriers at and around the second surface of the substrate 110 and improves an inner reflectance of light passing through the substrate 110, thereby increasing reincidence of light passing through the substrate 110. The back passivation layer 190 may have a single-layered structure or a multi-layered structure. For example, when the back passivation layer 190 has the multi-layered structure, the back passivation layer 190 may include three layers. In this instance, the back passivation layer 190 may include a silicon oxide (SiOx) layer, a silicon nitride (SiNx) layer, and a silicon oxynitride (SiOxNy) layer from the substrate 110.

As described above, the second electrode 150 may include the back electrode layer 151 and the plurality of second bus bar electrodes 152.

The back electrode layer 151 is positioned on the back passivation layer 190 so that it covers the entire surface of the back passivation layer 190. The back electrode layer 151 may include a plurality of connection portions 151C electrically connected to the substrate 110 through the holes of the back passivation layer 190.

The back electrode layer 151 may be formed of a conductive material such as aluminum (Al). For example, the back electrode layer 151 may be formed of at least one selected from the group consisting of nickel (Ni), copper (Cu), silver (Ag), tin (Sn), zinc (Zn), indium (In), titanium (Ti), gold (Au), and a combination thereof. Alternatively, other materials may be used.

The second bus bar electrodes 152 are positioned on the back passivation layer 190 and are electrically connected to the back electrode layer 151. The second bus bar electrodes 152 may have a stripe shape extending in the same direction as the first bus bar electrodes 142. In this instance, the second bus bar electrodes 152 may be positioned at a location opposite the first bus bar electrodes 142.

The second bus bar electrodes 152 may be formed of the same material as the first bus bar electrodes 142 and may have the same structure as the first bus bar electrodes 142.

Accordingly, the second bus bar electrodes 152 may include electrically conductive metal particles and a thermosetting resin. Further, the structure and the material of the first bus bar electrodes 142 illustrated in FIG. 4 may be applied to the second bus bar electrodes 152, and thus a further description may be briefly made or may be entirely omitted.

As described above, in the fourth embodiment of the invention, because the first finger electrodes 141 and the first bus bar electrodes 142 are manufactured using the different manufacturing methods, the first finger electrodes 141 and the first bus bar electrodes 142 may include the different electrode structures and the different materials. Hence, the efficiency and the productivity of the solar cell may be improved due to the different manufacturing methods between the first finger electrodes 141 and the first bus bar electrodes 142.

So far, the embodiment of the invention described the structure of the solar cell, in which the first finger electrode 141 includes the seed layer 141S and the conductive metal layer 141M and the first bus bar electrode 142 includes the electrically conductive metal particles MB and the thermosetting resin RS. A method for manufacturing the solar cell according to the embodiment of the invention is described below.

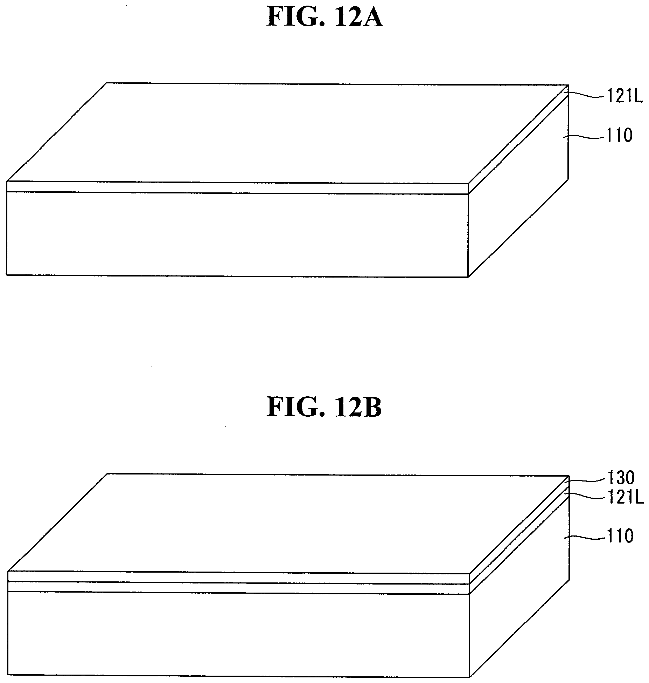

FIGS. 12A to 12G illustrate a method for manufacturing the solar cell according to the embodiment of the invention.

The method for manufacturing the solar cell illustrated in FIGS. 12A to 12G is described based on the solar cell shown in FIG. 6 as an example. Thus, it is a matter of course that the method for manufacturing the solar cell according to the embodiment of the invention may be applied to all kinds of solar cells, in which in which the first electrode includes the first finger electrodes and the first bus bar electrodes.

In this instance, the first finger electrode 141 is formed using the plating method and includes the seed layer 141S and the conductive metal layer 141M, and the first bus bar electrode 142 is formed using a bus bar paste P142 including the electrically conductive metal particles MB and the thermosetting resin RS and has the structure including the electrically conductive metal particles MB and the thermosetting resin RS.

The method for manufacturing the solar cell according to the embodiment of the invention is described in detail below.

First, as shown in FIG. 12A, a lightly doped emitter region 121L, which contains impurities of a second conductive type opposite a first conductive type and has a first sheet resistance, is formed at a first surface of a substrate 110 containing impurities of the first conductive type.

The first surface of the substrate 110 may be textured to form a textured surface corresponding to an uneven surface having a plurality of uneven portions or having uneven characteristics in a previous process. Thus, the lightly doped emitter region 121L formed at the first surface of the substrate 110 may have a textured surface including a plurality of uneven portions.

The lightly doped emitter region 121L may be formed by diffusing a gas containing the impurities of the second conductive type into the first surface of the substrate 110 containing the impurities of the first conductive type in a chamber.

Next, as shown in FIG. 12B, a first dielectric layer 130 may be formed on the lightly doped emitter region 121L. The first dielectric layer 130 may be formed by depositing a process gas in a chamber using a chemical vapor deposition (CVD) method such as a plasma enhanced chemical vapor deposition (PECVD) method. In this instance, a kind and a pressure of the process gas may be changed, if necessary or desired. The first dielectric layer 130 may have a single-layered structure or a multi-layered structure. For example, the first dielectric layer 130 may include at least one of a silicon nitride (SiNx) layer, a silicon oxide (SiOx) layer, or a silicon oxynitride (SiOxNy) layer, each of which is formed on the lightly doped emitter region 121L through the deposition of the process gas and contains hydrogen (H).

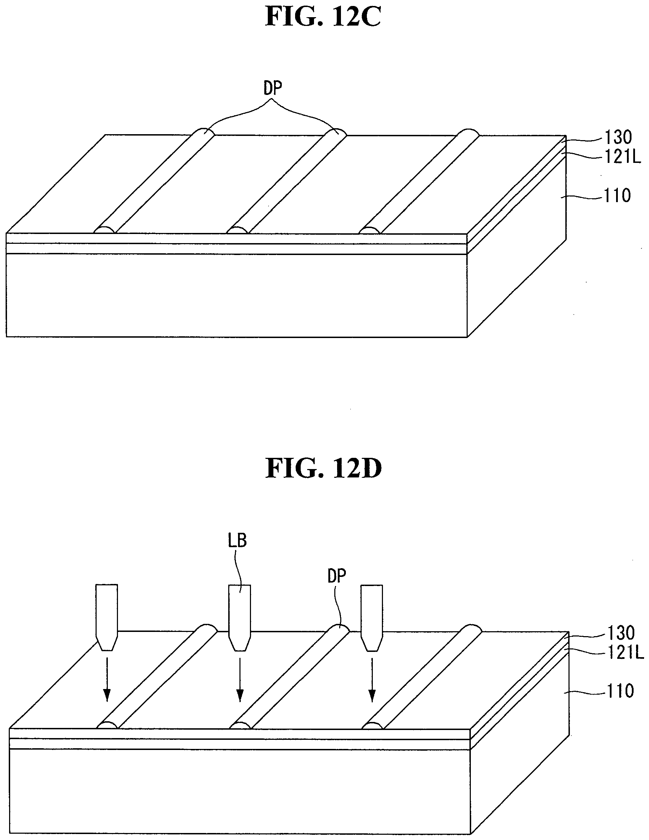

Next, as shown in FIGS. 12C to 12E, the first dielectric layer 130 is partially etched to form a heavily doped emitter region 121H, which has a second sheet resistance less than the first sheet resistance, at the lightly doped emitter region 121L exposed by the partial etching of the first dielectric layer 130.

More specifically, as shown in FIG. 12C, a dopant paste DP, which has the same pattern as first finger electrodes 141 in a first direction and contains the impurities of the second conductive type, is coated on a portion of the first dielectric layer 130.

The dopant paste DP may be coated using an inkjet printing method, a spin coating method, or a screen printing method, etc.

The embodiment of the invention illustrated and described that the dopant paste DP is coated on a portion of the first dielectric layer 130 in the first direction having the same pattern as the first finger electrodes 141. However, the dopant paste DP may be coated on the entire surface of the first dielectric layer 130. The heavily doped emitter region 121H may be simply formed without the use of a separate mask, etc. However, in this instance, an amount of the dopant paste DP used increases, and thus the manufacturing cost may increase.

As shown in FIG. 12D, when the dopant paste DP is partially coated on the first dielectric layer 130 in the first direction, a laser irradiation device LB selectively irradiates a laser beam onto the dopant paste DP while moving in the first direction.

In other words, the laser beam may be selectively irradiated only onto a portion of the substrate 110, on which the dopant paste DP is coated.

This process may be equally applied when the dopant paste DP is coated on the entire surface of the first dielectric layer 130. Namely, when the dopant paste DP is coated on the entire surface of the first dielectric layer 130, the laser beam may be selectively irradiated only onto a portion of the substrate 110, on which the dopant paste DP is coated (i.e., the first finger electrodes 141 will be formed).

As shown in FIG. 12D, the plurality of laser irradiation devices LB may be used. Alternatively, one laser irradiation device LB may be repeatedly used several times.

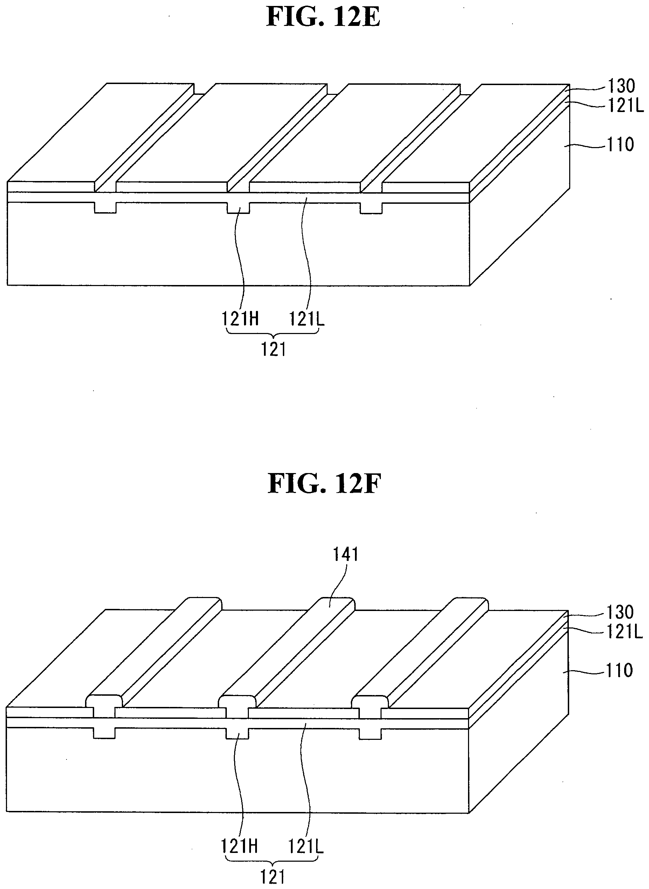

As shown in FIG. 12E, when the laser beam is irradiated onto the dopant paste DP on the first dielectric layer 130, a portion of the first dielectric layer 130 is etched, and at the same time impurities of the dopant paste DP are diffused into the lightly doped emitter region 121L. Hence, the heavily doped emitter region 121H may be formed at a portion of the lightly doped emitter region 121L.

The heavily doped emitter region 121H may have a stripe shape elongating in the same pattern (i.e., the first direction) as the first finger electrodes 141.

As shown in FIG. 12E, a portion of the first dielectric layer 130 may be etched to have the stripe shape. Alternatively, a portion of the first dielectric layer 130 may be etched to include a plurality of openings having a stripe arrangement.

The above-described process for etching a portion of the first dielectric layer 130 may be performed by adjusting a moving velocity or an output power of the laser beam.

For example, as shown in FIG. 12E, when the moving velocity of the laser beam relatively decreases and the output power of the laser beam relatively increases, the etched portion of the first dielectric layer 130 may have the stripe shape.

On the contrary, unlike FIG. 12E, when the moving velocity of the laser beam relatively increases and the output power of the laser beam relatively decreases, the etched portion of the first dielectric layer 130 may include the plurality of openings having the stripe arrangement.

In this instance, a width of the first dielectric layer 130 etched by the laser beam may be less than a width W141 (refer to FIG. 2A) of the first finger electrode 141.

A remainder of the first dielectric layer 130 etched by the laser beam and a remainder of the dopant paste DP may be removed.

Next, as shown in FIG. 12F, the first finger electrodes 141 may be formed on the heavily doped emitter region 121H in the first direction. The first finger electrodes 141 may be formed using the plating method.

Accordingly, a process for forming the first finger electrodes 141 may include a process for forming a seed layer 141S on the heavily doped emitter region 121H and a process for forming a conductive metal layer 141M on the seed layer 141S. Hence, as shown in FIG. 3, the first finger electrode 141 may include the seed layer 141S and the conductive metal layer 141M.

Since the materials of the seed layer 141S and the conductive metal layer 141M are substantially the same as those illustrated in FIG. 3, a further description may be briefly made or may be entirely omitted.

As described above, when the first finger electrodes 141 are formed using the plating method, the first finger electrodes 141 may be more simply manufactured because a separate alignment process is not required. Further, because an area, onto which the laser beam is irradiated, is reduced, a heat damage of the emitter region 121 or the substrate 110 may be reduced. Furthermore, when the first finger electrodes 141 are manufactured, the shunt phenomenon, in which the first finger electrodes 141 pass through the emitter region 121 and contact the substrate 110, is prevented. Hence, the production yield of the solar cell may be further improved.

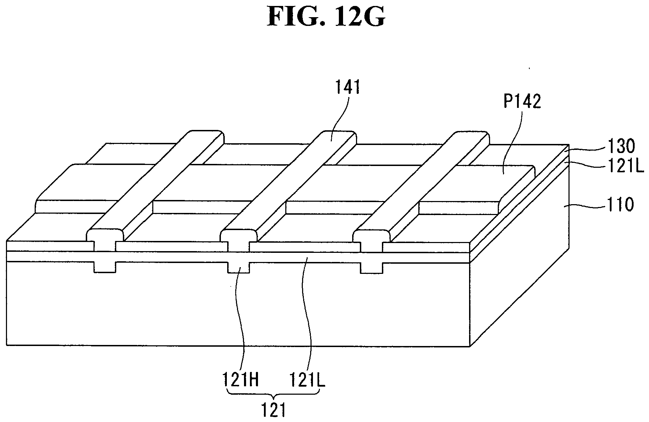

Next, as shown in FIG. 12G, a bus bar paste P142 including electrically conductive metal particles MB and a thermosetting resin RS is coated in a second direction crossing the first direction of the first finger electrodes 141 and then form first bus bar electrodes 142 through a low temperature process.

Further, a nickel-silicide layer, which is generated by chemical bonding between nickel (Ni) and silicon (Si) through a silicidation process, may be formed at an interface between the seed layer 141S of the first finger electrode 141 and the heavily doped emitter region 121H through the low temperature process of the bus bar paste P142.

The metal particles MB of the bus bar paste P142 may contain a conductive metal, for example, silver (Ag). In this instance, the metal particles MB may have a circle shape or an oval shape.

A diameter of each of the metal particles MB may be equal to or less than about 1 µm, and the bus bar paste P 142 may not include a glass frit.

The thermosetting resin RS of the bus bar paste P142 may include a monomer-based epoxy resin or an acrylic resin.

The bus bar paste P142 may further include an initiator generating a polymerization reaction.

The thermosetting resin RS coheres the metal particles MB and is hardened in the low temperature process (for example, about 300 °C to 350 °C). The initiator generates the polymerization reaction when the thermal process is performed on the bus bar paste P 142, and coheres the metal particles MB in the initial stage, thereby increasing the strength of the first bus bar electrode 142.

The bus bar paste P142 may not include the glass frit. Alternatively, even if the bus bar paste P142 includes the glass frit, an amount of the glass frit may be equal to or less than about 10 % per unit volume of the bus bar paste P142. The glass frit may contain a nonconductive material. As an amount of the nonconductive material increases, a resistance of the bus bar paste P142 increases. Therefore, the embodiment of the invention is described based on the bus bar paste P 142 not including the glass frit.

The low temperature process of the bus bar paste P142 may be performed at about 300 °C to 350 °C.

A temperature in the low thermal process of the bus bar paste P142 according to the embodiment of the invention is lower than the formation process temperature (for example, about 800 °C to 900 °C) of the related art bus bar electrode. Further, the bus bar paste P142 according to the embodiment of the invention does not include the glass frit, and the thermosetting resin RS is hardened in the low temperature process (for example, about 300 °C to 350 °C). Therefore, even if the thermal process is performed on the bus bar paste P142, the bus bar paste P142 does not pass through the first dielectric layer 130. Namely, as shown in FIG. 4, the thermosetting resin RS of the bus bar paste P142 remains in the first bus bar electrode 142, which is finally completed.

Because the thermal process temperature of the bus bar paste P142 is relatively low, the metal particles MB remaining in the bus bar paste P142 maintain an original shape. Namely, if each of the metal particles MB has the circle or oval shape before performing the low temperature process, the metal particles MB of the first bus bar electrode 142 which is finally completed, may maintain the original shape and thus have the circle shape or the oval shape. Further, because the thermal process temperature of the bus bar paste P142 is relatively low, a metal layer, which is recrystallized by a reaction between the metal particles MB and silicon of the emitter region 121, is not formed at an interface between the bus bar paste P142 and the emitter region 121.

The first bus bar electrodes 142 according to the embodiment of the invention are formed using the bus bar paste P142, which may be formed in the low temperature process (for example, about 300 °C to 350 °C). Therefore, the heat damage of the emitter region 121 and the substrate 110 may be reduced. As a result, the efficiency of the solar cell may be further improved.

Next, a back surface field region 172 and a second electrode 150 are formed on the second surface of the substrate 110. Hence, the solar cell shown in FIG. 6 may be completed.

## Claims

1. A solar cell comprising:
a substrate (110) containing impurities of a first conductive type;
an emitter region (121) positioned at a first surface of the substrate (110), the emitter region (121) containing impurities of a second conductive type opposite the first conductive type and including a lightly doped emitter region (121L) having a first sheet resistance and a heavily doped emitter region (121H) having a second sheet resistance less than the first sheet resistance;
a first dielectric layer (130) positioned on the emitter region (121);
a first electrode (140) including a first finger electrode (141) which is positioned on the heavily doped emitter region (121H) in a first direction, and a first bus bar electrode (142) which is positioned on the lightly doped emitter region (121L) in a second direction; and
a second electrode (150; 150') which is positioned on a second surface of the substrate (110) and is connected to the substrate (110),
wherein the first finger electrode (141) includes a seed layer (141S) contacting the heavily doped emitter region (121H) and a conductive metal layer (141M) formed on the seed layer (141S), and the first bus bar electrode (142) includes electrically conductive metal particles and a thermosetting resin, and
wherein the first dielectric layer (130) is positioned between the first bus bar electrode (142) and the lightly doped emitter region (121L).

2. The solar cell of claim 1, wherein the electrically conductive metal particles contain silver (Ag), and a size of each of the electrically conductive metal particles is equal to or less than about 1 µm.

3. The solar cell of claim 1, wherein the first bus bar electrode (142) lacks a glass frit or includes a glass frit equal to or less than about 10 % per unit volume of the first bus bar electrode (142).

4. The solar cell of claim 1, wherein the first bus bar electrode (142) lacks a metal layer recrystallized at an interface between the first bus bar electrode (142) and the emitter region (121).

5. The solar cell of claim 1, wherein the thermosetting resin includes a monomer-based epoxy resin or an acrylic resin.

6. The solar cell of claim 1, wherein the seed layer (141S) contains a nickel-silicide of nickel (Ni) and silicon (Si), and the conductive metal layer (141M) contains at least one of tin (Sn), copper (Cu), and silver (Ag).

7. The solar cell of claim 1, wherein the lightly doped emitter region (121L) directly contacts the first dielectric layer (130), and the first bus bar electrode (142) directly contacts the first dielectric layer (130).

8. The solar cell of claim 1, wherein the second electrode includes a second finger electrode (151; 151') positioned in the first direction and a second bus bar electrode (152; 152') positioned in the second direction crossing the first direction,
wherein the second finger electrode (151; 151') includes a seed layer (141S) and a conductive metal layer (141M) formed on the seed layer (141S), and the second bus bar electrode (152; 152') includes electrically conductive metal particles and a thermosetting resin.

9. A method for manufacturing a solar cell comprising:
forming a lightly doped emitter region (121L) having a first sheet resistance at a first surface of a substrate (110);
forming a first dielectric layer (130) on the lightly doped emitter region (121L);
coating a dopant paste on the first dielectric layer (130) and irradiating a laser beam onto the dopant paste to form a heavily doped emitter region (121H) having a second sheet resistance less than the first sheet resistance;
forming a first finger electrode (141) on the heavily doped emitter region (121H) in a first direction and forming a first bus bar electrode (142) on the lightly doped emitter region (121L) in a second direction to form a first electrode (140); and
forming a second electrode on a second surface of the substrate (110),
wherein the first finger electrode (141) of the first electrode (140) is formed using a plating method,
wherein the forming of the first bus bar electrode (142) of the first electrode (140) includes coating a bus bar paste (P142) including electrically conductive metal particles and a thermosetting resin and performing a predetermined temperature process on the bus bar paste (P142),
wherein the first finger electrode (141) is connected to the heavily doped emitter region (121H) exposed through a portion of the first dielectric layer (130) which is removed through the irradiation of the laser beam, and
wherein when the predetermined temperature process is performed on the bus bar paste (P142), the bus bar paste (P142) does not pass through the first dielectric layer (130).

10. The method of claim 9, wherein the predetermined temperature process of the bus bar paste (P142) is performed at about 300 °C to 350 °C.

11. The method of claim 10, wherein when the predetermined temperature process is performed on the bus bar paste (P142), a recrystallized metal layer is not formed at an interface between the bus bar paste (P142) and the emitter region (121).

12. The method of claim 10, wherein a shape of the electrically conductive metal particles after performing the predetermined temperature process is the same as a shape of the electrically conductive metal particles before performing predetermined low temperature process.

13. The method of claim 10, wherein the first finger electrode (141) includes a seed layer (141S) containing nickel (Ni) formed on the heavily doped emitter region (121H) and a conductive metal layer (141M) formed on the seed layer (141S),
wherein when the predetermined temperature process is performed on the bus bar paste (P142), a nickel-silicide layer generated by chemical bonding between nickel (Ni) and silicon (Si) of the heavily doped emitter region (121H) is formed on the seed layer (141S) of the first finger electrode (141).

## Patentansprüche

1. Solarzelle umfassend:
ein Substrat (110) enthaltend Störstellen eines ersten leitfähigen Typs;
einen Emitter-Bereich (121), der an einer ersten Oberfläche des Substrats (110) angeordnet ist, wobei der Emitter-Bereich (121) Störstellen eines zweiten leitfähigen Typs, der zu dem ersten leitfähigen Typ entgegengesetztes ist, enthält und einen leicht dotierten Emitter-Bereich (121H), mit einem ersten Schichtwiderstand und einen schwer dotierten Emitter-Bereich (121H) mit einem zweiten Schichtwiderstand, der kleiner ist als der erste Schichtwiderstand, einschließt;
eine erste dielektrische Schicht (130), die auf dem Emitter-Bereich (121) angeordnet ist;
eine erste Elektrode (140), die eine erste Fingerelektrode (141), die auf dem schwer dotierten Emitter-Bereich (121H) in einer ersten Richtung positioniert ist, und eine erste Sammelschienenelektrode (142), die auf dem schwer dotierten Emitter-Bereich (121L) in einer zweiten Richtung angeordnet ist, einschließt; und
eine zweite Elektrode (150; 150'), die auf einer zweiten Oberfläche des Substrats (110) angeordnet ist und mit dem Substrat (110) verbunden ist,
wobei die erste Fingerelektrode (141) eine Saatschicht (141S), welche den schwer dotierten Emitter-Bereich (121H) kontaktiert und eine leitfähige Metallschicht (141M), die auf der Saatschicht (141S) gebildet ist, einschließt, und die erste Sammelschienenelektrode (142) elektrisch leitfähige Metall-Partikel und ein wärmehärtendes Harz einschließt, und wobei die erste dielektrische Schicht 130 zwischen der ersten Sammelschienenelektrode (142) und dem leicht dotierten Emitter-Bereich (121L) angeordnet ist.

2. Solarzelle nach Anspruch 1, wobei die elektrisch leitfähigen Metall-Partikel Silber (Ag) enthalten, und eine Größe von jedem der elektrisch leitfähigen Metall-Partikel gleich zu oder kleiner als etwa 1 µm ist.

3. Solarzelle nach Anspruch 1, wobei die erste Sammelschienenelektrode (142) keine Glasfritte enthält oder eine Glasfritte enthält, die gleich zu oder weniger als etwa 10% pro Volumeneinheit der ersten Sammelschienenelektrode (142) ist.

4. Solarzelle nach Anspruch 1, wobei die erste Sammelschienenelektrode (142) keine an einer Schnittstelle zwischen der ersten Sammelschienenelektrode (142) und dem Emitter-Bereich (121) rekristallisierte Metallschicht aufweist.

5. Solarzelle nach Anspruch 1, wobei das wärmehärtende Harz ein Monomerbasiertes Epoxid-Harz oder ein Acryl-Harz einschließt.

6. Solarzelle nach Anspruch 1, wobei die Saatschicht (141S) ein Nickelsilizid aus Nickel (Ni) und Silizium (Si) enthält, und die leitfähige Metallschicht (141M) mindestens eines von Zinn (Sn), Kupfer (Cu) und Silber (Ag) enthält.

7. Solarzelle nach Anspruch 1, wobei der leicht dotierte Emitter-Bereich (121L) direkt die erste dielektrische Schicht (130) kontaktiert, und die erste Sammelschienenelektrode (142) direkt die erste dielektrische Schicht (130) kontaktiert.

8. Solarzelle nach Anspruch 1, wobei die zweite Elektrode eine zweite Fingerelektrode (151; 151'), die in der ersten Richtung angeordnet ist, und eine zweite Sammelschienenelektrode (152; 152'), die in der zweiten Richtung, welche die erste Richtung kreuzt, angeordnet ist, einschließt,
wobei die zweite Fingerelektrode (151; 151') eine Saatschicht (141S) und eine leitfähige Metallschicht (141M) die auf der Saatschicht (141S) gebildet ist, einschließt, und die zweite Sammelschienenelektrode (152; 152') elektrisch leitfähige Metall-Partikel und ein wärmehärtendes Harz einschließt.

9. Verfahren für die Herstellung einer Solarzelle, umfassend:
Bilden eines leicht dotierten Emitter-Bereichs (121L) mit einem ersten Schichtwiderstand an einer ersten Oberfläche eines Substrats (110);
Bilden einer ersten dielektrischen Schicht (130) auf dem leicht dotierten Emitter-Bereich (121L);
Beschichten einer Dotierpaste auf die erste dielektrische Schicht (130) und Strahlen eines Laserstrahls auf die Dotierpaste, um einen schwer dotierten Emitter-Bereich (121H) mit einem zweiten Schichtwiderstand, der weniger als der erste Schichtwiderstand ist, zu bilden;
Bilden einer ersten Fingerelektrode (141) auf dem schwer dotierten Emitter-Bereich (121H) in einer ersten Richtung und Bilden einer ersten Sammelschienenelektrode (142) auf dem leicht dotierten Emitter-Bereich (121L) in einer zweiten Richtung, um eine erste Elektrode (140) zu bilden; und
Bilden einer zweiten Elektrode auf einer zweiten Oberfläche des Substrats (110), wobei die erste Fingerelektrode (141) auf der ersten Elektrode (140) unter Verwendung eines Plattierungsverfahrens gebildet wird,
wobei das Bilden der ersten Sammelschienenelektrode (142) auf der ersten Elektrode (140) Beschichten einer Sammelschienen-Paste (P142), die elektrisch leitfähige Metall-Partikel und ein wärmehärtendes Harz einschließt, und Durchführen eines vorbestimmten Temperaturvorgangs auf die Sammelschienen-Paste (P142), einschließt,
wobei die erste Fingerelektrode (141) mit dem schwer dotierten Emitter-Bereich (121H), der durch einen Abschnitt der ersten dielektrischen Schicht (130), die durch die Bestrahlung mit dem Laserstrahl entfernt wird, verbunden wird, und
wobei, wenn der vorgegebene Temperaturvorgang an der Sammelschienenpaste (P142) durchgeführt wird, die Sammelschienenpaste (P142) nicht durch die erste dielektrische Schicht (130) passiert.

10. Verfahren nach Anspruch 9, wobei der vorgegebene Temperaturvorgang der Sammelschienenpaste (P142) bei etwa 300°C bis 350°C durchgeführt wird.

11. Verfahren nach Anspruch 10, wobei, wenn der vorgegebene Temperaturvorgang an der Sammelschienenpaste (P142) durchgeführt wird, eine rekristallisierte Metallschicht nicht an einer Schnittstelle zwischen der Sammelschienenpaste (P142) und dem Emitter-Bereich (121) gebildet wird.

12. Verfahren nach Anspruch 10, wobei eine Form der elektrisch leitfähigen Metall-Partikel nach dem Durchführen des vorgegebenen Temperaturvorgangs die Gleiche ist, wie eine Form der elektrisch leitfähigen Metall-Partikel vor dem Durchführen des vorgegebenen Niedrigtemperaturvorgangs.

13. Verfahren nach Anspruch 10, wobei die erste Fingerelektrode (141) eine Nickel (Ni) enthaltende Saatschicht (141S), die auf dem schwer dotierten Emitter-Bereich (121H) gebildet wird und eine leitfähige Metallschicht (141M), die auf der Saatschicht (141S) gebildet wird, enthält,
wobei, wenn der vorgegebene Temperaturvorgang auf der Sammelschienenpaste (P142) durchgeführt wird, eine Nickelsilizid-Schicht, die durch chemisches Verbinden zwischen Nickel (Ni) und Silizium (Si) des schwer dotierten Emitter-Bereichs (121H) erzeugt wird, auf der Saatschicht (141S) der ersten Fingerelektrode (141) gebildet wird.

## Revendications

1. Cellule solaire comprenant :
un substrat (110) contenant des impuretés d'un premier type de conductivité ;
une région d'émetteur (121) positionnée au niveau d'une première surface du substrat (110), la région d'émetteur (121) contenant des impuretés d'un deuxième type de conductivité opposé au premier type de conductivité et comprenant une région d'émetteur faiblement dopée (121L) ayant une première résistance de feuille et une région d'émetteur fortement dopée (121H) ayant une deuxième résistance de feuille inférieure à la première résistance de feuille ;
une première couche diélectrique (130) positionnée sur la région d'émetteur (121) ;
une première électrode (140) comprenant une première électrode en forme de doigt (141) qui est positionnée sur la région d'émetteur fortement dopée (121H) dans une première direction, et une première électrode de barre omnibus (142) qui est positionnée sur la région d'émetteur faiblement dopée (121L) dans une deuxième direction ; et
une deuxième électrode (150 ; 150') qui est positionnée sur une deuxième surface du substrat (110) et est connectée au substrat (110),
dans laquelle la première électrode en forme de doigt (141) comprend une couche d'ensemencement (141S) en contact avec la région d'émetteur fortement dopée (121H) et une couche métallique conductrice (141M) formée sur la couche d'ensemencement (141S), et la première électrode de barre omnibus (142) comprend des particules métalliques électriquement conductrices et une résine thermodurcissable, et
dans laquelle la première couche diélectrique (130) est positionnée entre la première électrode de barre omnibus (142) et la région d'émetteur faiblement dopée (121L).

2. Cellule solaire selon la revendication 1, dans laquelle les particules métalliques électriquement conductrices contiennent de l'argent (Ag), et une taille de chacune des particules métalliques électriquement conductrices est inférieure ou égale à environ 1 µm.

3. Cellule solaire selon la revendication 1, dans laquelle la première électrode de barre omnibus (142) n'a pas de fritte de verre ou comprend une fritte de verre inférieure ou égale à environ 10 % par unité de volume de la première électrode de barre omnibus (142).

4. Cellule solaire selon la revendication 1, dans laquelle la première électrode de barre omnibus (142) n'a pas de couche métallique recristallisée au niveau d'une interface entre la première électrode de barre omnibus (142) et la région d'émetteur (121).

5. Cellule solaire selon la revendication 1, dans laquelle la résine thermodurcissable comprend une résine époxyde à base de monomère ou une résine acrylique.

6. Cellule solaire selon la revendication 1, dans laquelle la couche d'ensemencement (141S) contient un siliciure de nickel de nickel (Ni) et de silicium (Si), et la couche métallique conductrice (141M) contient au moins un élément parmi l'étain (Sn), le cuivre (Cu) et l'argent (Ag).

7. Cellule solaire selon la revendication 1, dans laquelle la région d'émetteur faiblement dopée (121L) est directement en contact avec la première couche diélectrique (130), et la première électrode de barre omnibus (142) est directement en contact avec la première couche diélectrique (130).

8. Cellule solaire selon la revendication 1, dans laquelle la deuxième électrode comprend une deuxième électrode en forme de doigt (151 ; 151') positionnée dans la première direction et une deuxième électrode de barre omnibus (152 ; 152') positionnée dans la deuxième direction croisant la première direction,
dans laquelle la deuxième électrode en forme de doigt (151 ; 151') comprend une couche d'ensemencement (141S) et une couche métallique conductrice (141M) formée sur la couche d'ensemencement (141S), et la deuxième électrode de barre omnibus (152 ; 152') comprend des particules métalliques électriquement conductrices et une résine thermodurcissable.

9. Procédé de fabrication d'une cellule solaire comprenant :
la formation d'une région d'émetteur faiblement dopée (121L) ayant une première résistance de feuille au niveau d'une première surface d'un substrat (110) ;
la formation d'une première couche diélectrique (130) sur la région d'émetteur faiblement dopée (121L) ;
l'application d'une pâte de dopant sur la première couche diélectrique (130) et l'irradiation d'un faisceau laser sur la pâte de dopant pour former une région d'émetteur fortement dopée (121H) ayant une deuxième résistance de feuille inférieure à la première résistance de feuille ;
la formation d'une première électrode en forme de doigt (141) sur la région d'émetteur fortement dopée (121H) dans une première direction, et la formation d'une première électrode de barre omnibus (142) sur la région d'émetteur faiblement dopée (121L) dans une deuxième direction pour former une première électrode (140) ; et
la formation d'une deuxième électrode sur une deuxième surface du substrat (110),
dans laquelle la première électrode en forme de doigt (141) de la première électrode (140) est formée à l'aide d'un procédé de placage,
dans laquelle la formation de la première électrode de barre omnibus (142) de la première électrode (140) comprend l'application d'une pâte de barre omnibus (P142) comprenant des particules métalliques électriquement conductrices et une résine thermodurcissable et la réalisation d'un processus de température prédéterminée sur la pâte de barre omnibus (P142),
dans laquelle la première électrode en forme de doigt (141) est connectée à la région d'émetteur fortement dopée (121H) exposée par une partie de la première couche diélectrique (130) qui est éliminée par l'irradiation du faisceau laser, et
dans laquelle lorsque le processus de température prédéterminée est réalisé sur la pâte de barre omnibus (P142), la pâte de barre omnibus (P142) ne passe pas à travers la première couche diélectrique (130).

10. Procédé selon la revendication 9, dans lequel le processus de température prédéterminée de la pâte de barre omnibus (P142) est réalisé à environ 300 °C à 350 °C.

11. Procédé selon la revendication 10, dans lequel lorsque le processus de température prédéterminée est réalisé sur la pâte de barre omnibus (P142), une couche métallique recristallisée n'est pas formée à l'interface entre la pâte de barre omnibus (P142) et la région d'émetteur (121).

12. Procédé selon la revendication 10, dans lequel une forme des particules métalliques électriquement conductrices après la réalisation du processus de température prédéterminée est identique à une forme des particules métalliques électriquement conductrices avant la réalisation d'un processus à basse température prédéterminée.

13. Procédé selon la revendication 10, dans lequel la première électrode en forme de doigt (141) comprend une couche d'ensemencement (141S) contenant du nickel (Ni) formée sur la région d'émetteur fortement dopée (121H) et une couche métallique conductrice (141M) formée sur la couche d'ensemencement (141S),
dans lequel lorsque le processus de température prédéterminée est réalisé sur la pâte de barre omnibus (P142), une couche de siliciure de nickel générée par liaison chimique entre le nickel (Ni) et le silicium (Si) de la région d'émetteur fortement dopée (121H) est formée sur la couche d'ensemencement (141S) de la première électrode en forme de doigt (141).
